# FASCICULE DE BREVET EUROPEEN

(11) **EP 3 969 366 B1**
(45) Date de publication et mention de la délivrance du brevet: **08.01.2025**
(21) Numéro de dépôt: 20731922.9
(22) Date de dépôt: 04.05.2020
(51) Int. Cl.: B64C 39/02, B64D 45/00, B64C 27/00, H02G 1/02, H05K 9/00

(54) **VÉHICULE AÉRIEN SANS HUMAIN À BORD À BOÎTIER ÉLECTROMAGNÉTIQUEMENT PROTECTEUR ET VOILURE MÉCANIQUEMENT PROTÉGÉE**
UNBEMANNTES LUFTFAHRZEUG MIT EINEM ELEKTROMAGNETISCH ABGESCHIRMTEN GEHÄUSE UND EINEM MECHANISCH GESCHÜTZTEN FLÜGEL
UNMANNED AERIAL VEHICLE HAVING AN ELECTROMAGNETICALLY SHIELDED HOUSING AND A MECHANICALLY PROTECTED WING

(30) Priorité: 16.05.2019 FR 1905145
(43) Date de publication de la demande: 23.03.2022
(73) Titulaire: RTE RESEAU DE TRANSPORT D'ELECTRICITE, 92073 Paris La Défense Cedex (FR)
(72) Inventeur: POSLUSZNY, Thomas, 91080 Courcouronnes (FR)
(74) Mandataire: Bonnet, Michel
(86) Numéro de dépôt international: PCT/FR2020/050738
(87) Numéro de publication internationale: WO 2020/229750

(56) Documents cités:
- CN-U- 207 346 094
- CN-U- 207 843 308
- US-A1- 2012 083 945
- PIENAAR H ET AL: "RF shielding for multi-copter based electromagnetic metrology platforms", 2016 IEEE CONFERENCE ON ANTENNA MEASUREMENTS & APPLICATIONS (CAMA), IEEE, 23 October 2016 (2016-10-23), pages 1 - 4, XP033040949, DOI: 10.1109/CAMA.2016.7815781

## Description

La présente invention concerne un véhicule aérien sans humain à bord, ou aéronef sans pilote télécommandé.

Un tel véhicule est encore généralement appelé drone aérien, désigné par le sigle UAV (de l'anglais « Unmanned Aerial Vehicle »), ou par le sigle UAS (de l'anglais « Unmanned Air System »), ou par le sigle RPAS (de l'anglais « Remotely Piloted Aircraft System »), et comporte :
- une source d'alimentation électrique autonome,
- un boîtier dans le volume intérieur duquel sont disposés des équipements électroniques alimentés électriquement par la source d'alimentation, parmi lesquels un autopilote électronique, au moins un contrôleur d'au moins un moteur et un émetteur/récepteur radiofréquence pour un actionnement télécommandé en propulsion ou sustentation du véhicule aérien,
- au moins une voilure de maintien en vol par propulsion ou sustentation sur télécommande des équipements électroniques.

Ce type de véhicule aérien télécommandé est de plus en plus utilisé en surveillance ou maintenance et son boîtier comporte avantageusement une paroi conductrice d'électricité s'étendant de manière à protéger les équipements électroniques qu'il contient de tout champ électromagnétique extérieur. Il permet ainsi de protéger ses équipements électroniques contre les interférences électromagnétiques qui peuvent perturber sa stabilité en vol et la précision de ses mesures ou instructions. Un exemple est par exemple illustré et décrit dans le document de modèle d'utilité CN 206384132 U. Le document US 2012/083945 A1 divulgue un hélicoptère multirotor à échelle réduite, destiné par exemple à une application industrielle, doté de plusieurs trains d'atterrissage s'étendant à partir de la cellule, et d'un émetteur/récepteur standard qui transmet et reçoit les instructions de l'unité de commande à distance.

Pour des questions de maniabilité et de réactivité aux télécommandes, ce type de véhicule comporte plus précisément et avantageusement au moins une voilure tournante à hélice entrainée par au moins un moteur commandé par ledit au moins un contrôleur. De plus, pour chaque hélice motorisée, un élément structurel de protection mécanique est généralement prévu.

Une application particulièrement sensible, parce qu'elle concerne des environnements très exposés aux champs électromagnétiques puissants, est la surveillance et la maintenance des installations de transport et/ou de distribution d'électricité par lignes à hautes et très hautes tensions. Si la structure proposée ci-dessus peut suffire dans un voisinage assez large, l'approche au plus près des postes électriques ou des lignes à hautes ou très hautes tensions est susceptible d'engendrer des arcs électriques et des champs électromagnétiques puissants contre lesquels ce type de drone n'est en réalité pas suffisamment protégé parce qu'insuffisamment robuste. En particulier, chaque hélice motorisée, même mécaniquement protégée, représente une zone de fragilité de l'ensemble, notamment une zone d'amorçage pour tout arc électrique potentiel.

Plus généralement, toute application impliquant une exposition aux champs électromagnétiques puissants est concernée, comme par exemple la surveillance et la maintenance d'un réseau électrique ferroviaire, ou même de tout type de réseau ou équipement électrique sous tension.

Il peut ainsi être souhaité de concevoir un véhicule aérien sans humain à bord qui permette de s'affranchir au moins en partie du problème de fragilité précité.

Il est donc proposé un véhicule aérien sans humain à bord comportant :
- une source d'alimentation électrique autonome,
- un boîtier dans le volume intérieur duquel sont disposés des équipements électroniques alimentés électriquement par la source d'alimentation, parmi lesquels un autopilote électronique, au moins un contrôleur d'au moins un moteur d'hélice et un émetteur/récepteur radiofréquence pour un actionnement télécommandé en propulsion ou sustentation du véhicule aérien, le boîtier comportant une paroi conductrice d'électricité s'étendant de manière à protéger ces équipements électroniques de tout champ électromagnétique extérieur au boîtier,
- au moins une voilure tournante à hélice motorisée de maintien en vol par propulsion ou sustentation sur télécommande des équipements électroniques, et
- pour chaque hélice motorisée, un élément structurel de protection mécanique,
dans lequel une bande conductrice d'électricité électriquement raccordée à la paroi conductrice du boîtier s'étend en périphérie de chaque élément structurel de protection mécanique d'hélice en tant que qu'élément rapporté ou constitué par dépôt direct d'un matériau électriquement conducteur en périphérie de l'élément structurel de protection mécanique selon une méthode de traitement de surface.

Ainsi, chaque hélice et son moteur associé sont non seulement mécaniquement mais également électromagnétiquement protégés contre toute approche de poste électrique ou ligne à haute ou très haute tension, ou plus généralement de tout équipement électrique source d'un champ électromagnétique intense, en particulier contre tout arc électrique qu'une trop grande proximité pourrait engendrer.

De façon optionnelle :
- chaque élément structurel de protection mécanique est en forme de portion de roue, disposée sous et centrée sur l'hélice qu'il protège, dont le rayon est en outre supérieur à la longueur de chaque pale de l'hélice qu'il protège, et
- chaque bande conductrice s'étend circulairement en périphérie extérieure de chaque portion de roue.

De façon optionnelle également :
- chaque élément structurel de protection mécanique en forme de portion de roue comporte un support central, au milieu duquel est montée l'hélice motorisée correspondante, une jante en portion circulaire et plusieurs rayons s'étendant latéralement depuis le support central vers la jante, dont deux rayons extérieurs entre les extrémités éloignées desquels s'étend la jante, et
- chaque bande conductrice s'étend circulairement en périphérie extérieure de la jante et linéairement le long des deux rayons extérieurs jusqu'au support central de l'élément structurel de protection mécanique qui la porte.

De façon optionnelle également, un véhicule aérien sans humain à bord selon l'invention peut comporter plusieurs voilures tournantes à hélices motorisées, chaque voilure tournante étant déportée latéralement à l'aide d'un bras s'étendant à partir d'un châssis sur lequel est monté le boîtier et chaque bande conductrice étant raccordée électriquement au boîtier par l'intermédiaire du bras correspondant.

De façon optionnelle également, chaque élément structurel de protection mécanique est fixé à l'extrémité déportée de l'un des bras par son support central, à l'aide au moins de la bande conductrice qu'il porte.

De façon optionnelle également, un véhicule aérien sans humain à bord selon l'invention peut comporter un pied d'appui au sol sous chacune d'au moins une partie de ladite au moins une voilure tournante.

De façon optionnelle également, chaque pied d'appui au sol est formé d'au moins une partie enveloppante en matériau conducteur d'électricité et une partie de consolidation en matériau de résistance mécanique plus élevée que la partie enveloppante.

De façon optionnelle également, la partie enveloppante en matériau conducteur de chaque pied d'appui au sol est raccordée électriquement à la bande conductrice de l'élément structurel de protection mécanique d'hélice correspondant.

De façon optionnelle également, chaque élément structurel de protection mécanique d'hélice est en matériau diélectrique.

De façon optionnelle également, chaque hélice motorisée comporte un moteur électrique à protection électromagnétique intégrée et une hélice à pales en matériau diélectrique vissée sur le moteur électrique à l'aide d'un écrou en matériau diélectrique ou recouvert d'un capuchon en matériau diélectrique.

L'invention sera mieux comprise à l'aide de la description qui va suivre, donnée uniquement à titre d'exemple et faite en se référant aux dessins annexés dans lesquels :
[Fig.1] la figure 1 représente en perspective assemblée vue de dessus la structure générale d'un drone aérien selon un mode de réalisation de l'invention,
[Fig.2] la figure 2 représente en perspective assemblée vue de dessous le drone aérien de la figure 1,
[Fig.3] la figure 3 représente en perspective assemblée vue de dessus un châssis et quatre bras latéraux du drone aérien de la figure 1,
[Fig.4] la figure 4 représente schématiquement le contenu avec raccordements électriques d'un boîtier d'équipements électroniques du drone aérien de la figure 1,
[Fig.5] la figure 5 représente en perspective assemblée vue de dessus une hélice motorisée du drone aérien de la figure 1,
[Fig.6] la figure 6 représente en perspective assemblée vue de dessus un élément structurel de protection mécanique d'hélice du drone aérien de la figure 1,
[Fig.7] la figure 7 illustre un détail de raccordement électrique au voisinage du boîtier de la figure 4,
[Fig.8] la figure 8 illustre un détail de raccordement électrique au voisinage de l'hélice motorisée de la figure 5, et
[Fig.9] la figure 9 représente schématiquement en coupe un raccordement d'antenne du drone aérien de la figure 1.

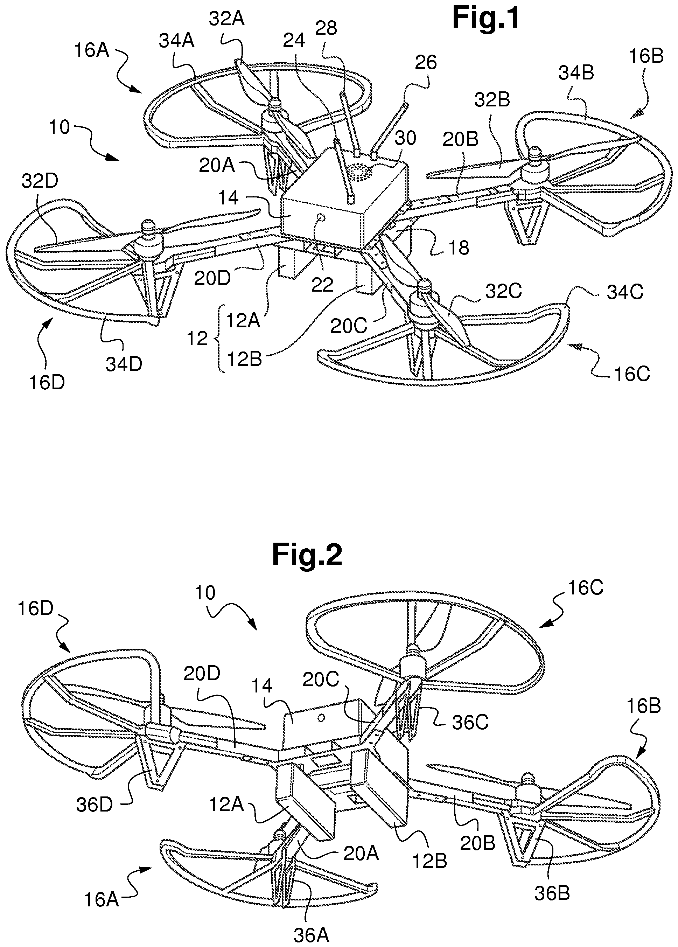

Le drone aérien 10 illustré en perspective sur la figure 1 comporte une source d'alimentation électrique autonome 12, constituée d'au moins une batterie insérée dans au moins un boîtier, par exemple de deux batteries insérées dans deux boîtiers 12A et 12B, un boîtier central 14, dans le volume intérieur duquel sont disposés des équipements électroniques alimentés électriquement par la source d'alimentation 12, et quatre voilures latérales 16A, 16B, 16C, 16D de maintien en vol du drone 10 par propulsion ou sustentation sur télécommande (non illustrée) des équipements électroniques du boîtier central 14. Conformément à la présente invention, le boîtier central 14 comporte une paroi conductrice d'électricité s'étendant de manière à protéger les équipements électroniques qu'il contient de tout champ électromagnétique extérieur. De même, les deux boîtiers 12A et 12B comportent avantageusement des parois conductrices d'électricité s'étendant de manière à protéger les batteries qu'ils contiennent de tout champ électromagnétique extérieur. Celles-ci présentent par ailleurs avantageusement des coques rigides en plastique pour une bonne isolation électrique de leurs cellules. Elles ne présentent optionnellement pas de capteur de tension pour limiter les risques de perturbations électromagnétiques, ce dernier pouvant être disposé à une jonction des deux batteries à l'intérieur du boîtier central 14.

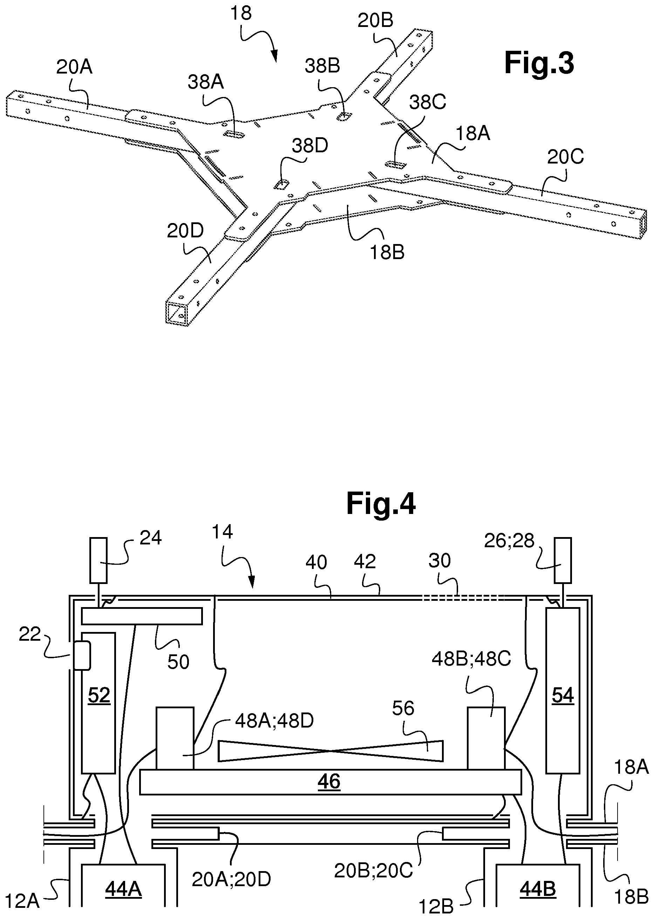

Le boîtier central 14 est plus précisément monté et fixé sur un châssis 18, sous lequel sont également montés et fixés les deux boîtiers 12A et 12B. Du châssis 18 s'étendent en outre latéralement, depuis le boîtier central 14, quatre bras rigides 20A, 20B, 20C, 20D aux extrémités distales desquels sont fixées les quatre voilures latérales 16A, 16B, 16C, 16D. Ils sont eux aussi fixés au châssis 18 par leurs extrémités proximales. Le châssis 18 sera plus précisément décrit en référence à la figure 3. Il est optionnellement mais avantageusement en matériau électriquement conducteur, comme la paroi conductrice du boîtier central 14 avec laquelle il est en contact par fixation de manière à assurer un raccordement électrique à un même potentiel de référence. De même, les quatre bras rigides 20A, 20B, 20C, 20D sont avantageusement en matériau électriquement conducteur, comme le châssis 18 avec lequel ils sont en contact par fixation de manière à assurer un raccordement électrique au potentiel de référence commun par continuité électrique entre la paroi conductrice du boîtier central 14, le châssis 18 et chaque bras rigide 20A, 20B, 20C, 20D.

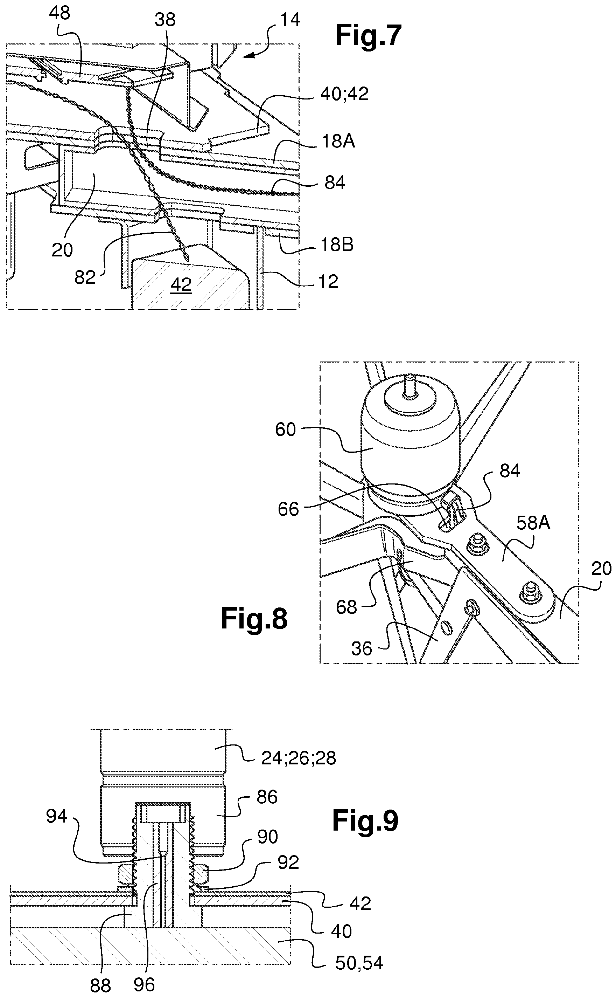

Le boîtier central 14 peut être de forme quelconque. Dans l'exemple non limitatif de la figure 1, il est parallélépipédique rectangle avec une face rectangulaire inférieure de sa paroi conductrice fixée au châssis 18, une face rectangulaire supérieure libre opposée au châssis 18 et quatre faces rectangulaires latérales. Sur l'une des quatre faces latérales, dite face avant, un trou traversant 22 est percé pour la disposition en vis-à-vis de l'objectif d'une caméra vidéo intégrée dans le volume intérieur du boîtier central 14. Sur la face supérieure opposée au châssis 18 trois antennes d'émission/réception radiofréquence, par exemple à 5,8 GHz, sont en outre fixées selon un mécanisme qui sera détaillé en référence à la figure 9. L'une de ces trois antennes, portant la référence 24 et disposée au voisinage de la face avant du boîtier central 14, est électriquement raccordée à un dispositif de télémesure intégré dans le volume intérieur du boîtier central 14. Les deux autres antennes, portant les références 26, 28 et disposées au voisinage de la face arrière du boîtier central 14, sont électriquement raccordées à un transmetteur vidéo intégré dans le volume intérieur du boîtier central 14. Enfin, un ensemble 30 de petits trous percés sur la face supérieure du boîtier central 14 à proximité des deux antennes 26 et 28 permet d'évacuer la chaleur dissipée par les équipements électroniques intégrés dans le volume intérieur du boîtier central 14. Le contenu électronique de ce volume intérieur sera détaillé en référence à la figure 4.

On notera que les trous 22, 30 aménagés dans la paroi conductrice du boîtier central 14 sont dimensionnés pour ne pas rompre la protection électromagnétique qu'elle doit assurer.

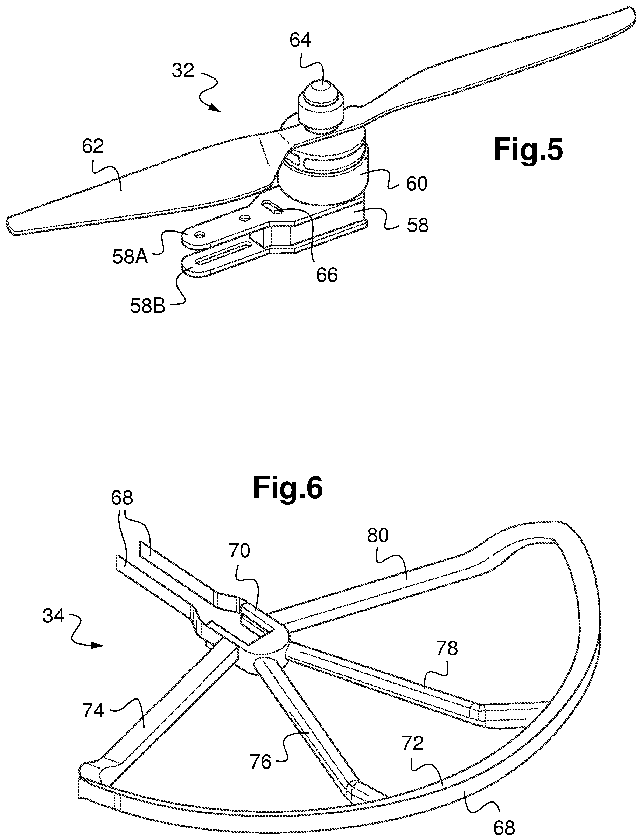

La voilure latérale 16A comporte une hélice motorisée 32A qui sera détaillée en référence à la figure 5. Cette hélice motorisée 32A est montée et fixée sur l'extrémité distale du bras rigide 20A. La voilure latérale 16A comporte en outre un élément structurel 34A de protection mécanique de l'hélice motorisée 32A, lui aussi monté et fixé sur l'extrémité distale du bras rigide 20A, placé sous l'hélice motorisée 32A. Il sera détaillé en référence à la figure 6. Les quatre voilures latérales étant identiques, la voilure latérale 16B comporte également une hélice motorisée 32B et un élément structurel de protection mécanique 34B, montés de la même manière sur le bras rigide 20B, la voilure latérale 16C comporte une hélice motorisée 32C et un élément structurel de protection mécanique 34C, montés sur le bras rigide 20C, et la voilure latérale 16D comporte une hélice motorisée 32D et un élément structurel de protection mécanique 34D, montés sur le bras rigide 20D.

Comme le montre la figure 2 qui illustre le drone aérien 10 en perspective vue de dessous, quatre pieds 36A, 36B, 36C, 36D sont montés et fixés respectivement sous les extrémités distales des quatre bras rigides 20A, 20B, 20C, 20D. Ils sont par exemple chacun constitués de deux plaques parallèles reliées par des colonnettes formant entretoises (non illustrées), chacune des deux plaques étant en forme de « A » inversé avec une prolongation latérale supérieure de montage et fixation contre le bras rigide correspondant. L'une des deux plaques est par exemple en matériau électriquement conducteur formant une partie enveloppante, ce qui lui permet, au vu de sa disposition en partie inférieure du drone 10 sous la voilure latérale correspondante, de dévier tout arc électrique éventuel pour qu'il ne frappe pas les autres équipements du drone 10. Sa fixation au bras rigide correspondant permet en outre un raccordement électrique au potentiel de référence commun. L'autre des deux plaques, formant une partie de consolidation, est par exemple en fibre de verre de même épaisseur, pour supporter la masse du drone 10 lorsqu'il est posé au sol. La fibre de verre peut être remplacée par tout autre matériau composite de résistance mécanique plus élevée que la partie enveloppante, notamment équivalente ou supérieure à celle de la fibre de verre.

Plus généralement, chaque pied d'appui au sol est avantageusement formé d'au moins une partie enveloppante en matériau conducteur d'électricité, quelle que soit sa structure et sa forme en plaque, tubulaire ou autre, et une partie de consolidation en matériau de résistance mécanique plus élevée que la partie enveloppante, quelle que soit également sa structure et sa forme en plaque, tubulaire ou autre. Le but est d'obtenir une résistance mécanique adaptée et une densité globale la plus faible possible tout en conservant une enveloppe conductrice d'électricité.

On notera qu'il peut être prévu un pied d'appui au sol par voilure, ou en variante des pieds d'appui au sol sur une partie seulement des voilures, ou même aucun pied d'appui au sol sous la ou les voilure(s), quel que soit le nombre de voilures.

La vue de dessous de la figure 2 permet en outre de noter que des accès indépendants aux batteries peuvent être aménagés sous les boîtiers 12A et 12B. Elles sont ainsi protégées contre tout champ électromagnétique extérieur comme les équipements électroniques intégrés dans le boîtier central 14, tout en pouvant être insérées ou extraites en toute indépendance. Les deux boîtiers 12A et 12B sont par ailleurs en contact avec le châssis 18 par fixation de manière à assurer un raccordement électrique au potentiel de référence commun.

En termes d'encombrement, un tel drone aérien 10 peut présenter des dimensions latérales inférieures à 1 m, une hauteur inférieure à 25 cm et un poids inférieur à 3 kg. Il est adapté, compte tenu de la disposition de ses antennes au-dessus du boîtier central 14 et de ses éléments structurels de protection mécanique 34A, 34B, 34C, 34D sous les hélices motorisées 32A, 32B, 32C, 32D pour une approche par le haut de la cible visée.

En termes de matériaux, le matériau électriquement conducteur employé pour les parois conductrices des boîtiers 14 et 12A, 12B, les plaques du châssis 18, les bras rigides 20A, 20B, 20C et 20D et les plaques conductrices des pieds 36A, 36B, 36C et 36D est par exemple de la tôle d'aluminium de 0,5 à 2 mm d'épaisseur : par exemple 0,5 mm pour les parois conductrices de boîtiers, 1 mm pour les plaques conductrices des pieds 36A, 36B, 36C et 36D, 1,5 mm pour les bras rigides 20A, 20B, 20C et 20D et 2 mm pour les plaques du châssis 18. En variante et pour un gain en masse et rigidité, il est tout à fait possible d'envisager un matériau composite incluant de l'aluminium ou tout autre matériau conducteur et de la fibre de verre, du carbone ou du plastique, par polymérisation ou métallisation.

La figure 3 est une représentation plus détaillée d'un mode de réalisation possible du châssis 18 et des quatre bras rigides 20A, 20B, 20C, 20D. Le châssis 18 est constitué de deux plaques parallèles 18A (plaque supérieure) et 18B (plaque inférieure) de mêmes dimensions rapportées l'une face à l'autre par entretoise. Elles sont de forme principale rectangulaire avec des extensions diagonales de fixations en leurs quatre coins. Chaque bras rigide 20A, 20B, 20C ou 20D est fixé et enserré entre les deux plaques 18A et 18B le long de l'extension diagonale correspondante, son extrémité proximale s'étendant vers le centre des deux plaques. Ce sont ainsi les extrémités proximales des quatre bras rigides 20A, 20B, 20C et 20D qui remplissent la fonction d'entretoise pour rapporter les deux plaques parallèles 18A et 18B l'une face à l'autre. La continuité électrique de tous ces éléments rend en outre l'entretoise elle-même électriquement conductrice. La figure 3 montre par ailleurs que la plaque supérieure 18A comporte quatre trous 38A, 38B, 38C, 38D respectivement disposés face aux quatre extrémités proximales des quatre bras rigides 20A, 20B, 20C, 20D. Leur fonction sera détaillée en référence aux figures 4 et 7.

La plaque supérieure 18A est destinée à recevoir le boîtier central 14, tandis que la plaque inférieure 18B est destinée à recevoir les deux boîtiers 12A et 12B.

La figure 4 représente en coupe schématique le boîtier central 14 de la figure 1, son environnement proche et son contenu.

Il comporte une paroi interne 40 électriquement isolante, par exemple en matériau plastique tel que du polyoxyméthylène d'une épaisseur de 2 mm, et une paroi externe 42 conductrice d'électricité formant le potentiel de référence commun précité, par exemple de 0,5 mm d'épaisseur. Ces deux parois sont rapportées l'une contre l'autre et percées pour former le trou 22 en face avant et l'ensemble 30 de petits trous en face supérieure. Elles sont en outre percées en face inférieure de quatre trous pour le passage de fils électriques. Ces quatre trous correspondent aux quatre trous 38A, 38B, 38C, 38D de la plaque supérieure 18A du châssis 18 et sont disposés face à eux lorsque le boîtier central 14 est monté et fixé sur le châssis 18.

En variante et selon les applications concrètes visées, la paroi interne 40 peut être supprimée pour alléger le drone aérien 10 si sa fonction d'isolation électrique n'est pas indispensable ou recherchée.

De même, les boîtiers 12A et 12B dans lesquels sont intégrées les batteries 44A et 44B présentent des trous dans leurs faces en contact avec la plaque inférieure 18B du châssis 18, cette dernière comportant également des trous correspondants.

Entre les deux plaques 18A et 18B du châssis, les quatre bras rigides 20A, 20B, 20C, 20D sont des tubes creux, par exemple de section rectangulaire ou même carrée 20×20 mm, obturés à leurs deux extrémités et présentent chacun deux trous dont l'un est contre la plaque supérieure 12A face à l'un de ses trous 38A, 38B, 38C, 38D et l'autre est contre la plaque inférieure 12B face à l'un de ses trous. Ainsi, des passages sont créés entre les volumes intérieurs du boîtier central 14, des deux boîtiers 12A, 12B et des quatre bras rigides 20A, 20B, 20C, 20D pour le passage de fils électriques entre certains équipements électroniques intégrés dans le boîtier central 14 et les batteries 44A, 44B intégrées dans les boîtiers 12A, 12B, ou entre certains équipements électroniques intégrés dans le boîtier central 14 et les hélices motorisées 32A, 32B, 32C, 32D déportées latéralement aux extrémités distales des bras rigides 20A, 20B, 20C, 20D. D'une façon plus générale, la section des tubes creux peut ne pas être rectangulaire, telle que ronde ou autre.

Les équipements électroniques disposés dans le volume intérieur du boîtier central 14 comportent un autopilote électronique 46, quatre contrôleurs 48A, 48B, 48C, 48D de moteurs des hélices motorisées 32A, 32B, 32C, 32D et un émetteur/récepteur radiofréquence 50, connecté en réception et transmission de données avec l'autopilote électronique 46, pour un actionnement télécommandé en propulsion ou sustentation du drone 10. Ils comportent en outre de façon optionnelle un dispositif de télémesure, une caméra 52, un transmetteur vidéo 54 et un dispositif de refroidissement de type ventilateur 56.

En ce qui concerne l'autopilote électronique 46, il a pour fonction d'adresser des ordres aux quatre contrôleurs 48A, 48B, 48C, 48D en fonction d'ordres reçus par télécommande et de capteurs inertiels, barométriques ou autres de navigation, pour assurer la stabilité et le déplacement du drone 10. Il comporte optionnellement mais avantageusement un compas électronique activable et désactivable par télécommande. Un tel compas est en effet sensible aux champs électromagnétiques intenses susceptibles de s'ajouter au champ magnétique terrestre. Il peut ainsi être activé tant qu'il est éloigné d'un tel champ électromagnétique intense, pour un maintien de cap automatisé, puis être désactivé par télécommande lorsqu'il approche d'une source de champ électromagnétique intense, par exemple un poste électrique ou une ligne de transport et/ou distribution d'électricité à haute tension, un réseau électrique ferroviaire, etc., auquel cas le cap doit alors être maintenu manuellement par l'opérateur en possession de la télécommande.

En ce qui concerne les contrôleurs 48A, 48B, 48C et 48D, ils alimentent et contrôlent les vitesses de rotation des moteurs des hélices motorisées 32A, 32B, 32C et 32D. Il y en a un par moteur. Ils sont disposés à l'intérieur du boîtier central 14 pour limiter les risques de perturbation du câblage très sensible entre chacun d'eux et l'autopilote électronique 46.

En ce qui concerne le ventilateur 56, sa présence dans le boîtier central 14 nécessite l'ensemble 30 de trous d'évacuation de chaleur. Mais en variante, pour une utilisation potentielle du drone 10 même en cas d'intempérie, celui-ci pourrait être rendu étanche en supprimant l'ensemble 30 de trous, en assurant que la paroi conductrice 42 entoure hermétiquement le volume intérieur du boîtier central 14 et en remplaçant le ventilateur 56 par un dissipateur thermique passif en contact avec la paroi conductrice 42, par exemple par l'intermédiaire d'une pâte thermique, pour une évacuation de la chaleur produite par les équipements électroniques précités via cette paroi conductrice. L'utilisation d'un dissipateur thermique passif en plus du ventilateur 56 est également envisageable. Dans ce cas, les parois 40 et 42 sont dotées de l'ensemble 30 de trous d'évacuation de chaleur.

Dans l'exemple non limitatif de la figure 4, l'émetteur/récepteur radiofréquence 50 est en fait intégré dans le dispositif de télémesure, de sorte que ce dernier est désigné par la même référence. C'est la raison pour laquelle le dispositif de télémesure 50 est finalement raccordé à l'antenne 24, lui permettant ainsi par ailleurs de transmettre des données de télémesure au sol. De même, le transmetteur vidéo 54 est raccordé aux antennes 26 et 28.

En ce qui concerne les alimentations, le dispositif de télémesure 50 et la caméra 52 sont alimentés électriquement par la batterie 44A à l'aide de fils électriques traversant les trous aménagés à cet effet dans les parois du boîtier central 14, dans les plaques du châssis 18, dans le ou les bras rigides correspondants et dans la paroi du boîtier 12A. L'autopilote électronique 46 et le transmetteur vidéo 54 sont alimentés électriquement par la batterie 44B à l'aide de fils électriques traversant les trous aménagés à cet effet dans les parois du boîtier central 14, dans les plaques du châssis 18, dans le ou les bras rigides correspondants et dans la paroi du boîtier 12B. Quant aux contrôleurs 48A, 48B, 48C, 48D et au ventilateur 56, ils peuvent être alimentés indirectement par la batterie 44B, comme illustrés sur la figure 4, via l'autopilote électronique 46. Ils pourraient tout aussi bien, en variante, être alimentés directement par l'une ou l'autre des deux batteries 44A, 44B.

En ce qui concerne plus généralement les équipements du drone aérien 10, tout autre équipement que ceux indiqués précédemment pourrait être ajouté, dans le boîtier central 14 ou ailleurs, notamment tout autre équipement électronique, électrique, mécanique, électromécanique, etc., tout en restant compatible avec les principes généraux de la présente invention.

Conformément à un premier aspect, l'autopilote électronique 46, les contrôleurs 48A, 48B, 48C, 48D et l'émetteur/récepteur radiofréquence intégré dans le dispositif de télémesure 50 sont chacun pourvus d'un port de connexion à un potentiel électrique de référence et tous ces ports de connexion sont électriquement raccordés à la paroi externe 42 conductrice d'électricité formant le potentiel de référence commun précité. Le cas échéant, c'est-à-dire lorsqu'ils sont eux-mêmes présents dans le boîtier central 14, la caméra 52, le transmetteur vidéo 54 et le ventilateur 56 sont eux aussi pourvus de ports de connexion au potentiel électrique de référence, tous électriquement raccordés à la paroi externe 42. De la sorte, tous ces équipements électroniques intégrés dans le boîtier central 14 sont électromagnétiquement protégés, entre eux et vis-à-vis de l'extérieur, contre tout arc électrique ou champ électromagnétique intense.

L'une quelconque des voilures latérales 16A, 16B, 16C, 16D, tournante et à hélice motorisée, va maintenant être détaillée en référence aux figures 5 et 6. Plus précisément, l'une quelconque des hélices motorisées 32A, 32B, 32C, 32D de voilure latérale est illustrée sur la figure 5 et est identifiée de façon générale par la référence 32. Plus précisément également, l'un quelconque des éléments structurels de protection 34A, 34B, 34C, 34D de voilure latérale est illustré sur la figure 6 et est identifié de façon générale par la référence 34.

L'hélice motorisée 32 de la figure 5 comporte une base 58 sur laquelle est fixé un moteur cylindrique 60 à protection électromagnétique intégrée. Sur l'axe d'entraînement en rotation de ce moteur cylindrique 60 est vissée une hélice 62 à deux pâles en matériau diélectrique, à l'aide d'un écrou 64 en matériau diélectrique ou recouvert d'un capuchon en matériau diélectrique pour éviter tout arc électrique arrivant sur le moteur 60 par le haut. Ce matériau diélectrique peut être du plastique ou, pour une meilleure tenue mécanique, un composite en fibre de verre, de carbone ou équivalent. La base 58 se prolonge longitudinalement par deux languettes, l'une supérieure 58A, l'autre inférieure 58B, de fixation à l'extrémité distale de l'un des bras rigides 20A, 20B, 20C et 20D. Cette extrémité distale de bras rigide est destinée à s'encastrer entre les deux languettes jusqu'à l'intérieur de la base 58 dans laquelle un évidement de forme correspondante est prévu. La fixation de l'hélice motorisée 32 se fait par vissage des languettes sur le bras rigide considéré.

On notera que le moteur cylindrique 60 est avantageusement, et de façon connue en soi, raccordé électriquement au potentiel de référence commun précité, par exemple via la base 58 et l'extrémité distale de bras correspondante.

Un trou 66 est aménagé en partie supérieure de la base 58 au plus près du moteur cylindrique 60. A ce trou correspond un trou dans l'extrémité distale du bras rigide destiné à s'encastrer dans la base 58, disposé en vis-à-vis lorsque le bras rigide est correctement encastré, pour le passage de fils électriques d'alimentation au droit du moteur cylindrique 60.

L'élément structurel de protection mécanique 34 de la figure 6 comporte, conformément à un deuxième aspect, relatif à la présente invention, une bande conductrice d'électricité 68.

Cette bande conductrice 68 peut être un élément rapporté, par exemple en tôle d'aluminium, qui s'étend sur la périphérie de l'élément structurel de protection mécanique 34, notamment au contact de cette dernière, et qui est conçu pour être électriquement raccordée à la paroi conductrice 42 du boîtier central 14. Ce raccordement peut se faire directement ou indirectement selon la configuration du drone aérien 10. Ainsi, l'hélice motorisée 32 que protège mécaniquement l'élément structurel 34 est également électromagnétiquement protégée contre tout arc électrique ou champ électromagnétique intense. Dans l'exemple non limitatif des figures 1, 2 et 6, les deux extrémités de la bande conductrice 68 sont configurées pour être fixées le long de l'extrémité distale du bras rigide qui porte l'élément structurel 34. Comme ce bras rigide est lui-même en matériau électriquement conducteur et électriquement raccordé à la paroi conductrice 42 du boîtier central 14, le raccordement électrique au potentiel de référence commun est indirect dans ce cas.

La bande conductrice 68 peut en variante être constituée par traitement de surface, par exemple par métallisation, c'est-à-dire par dépôt direct d'un matériau électriquement conducteur en périphérie de l'élément structurel de protection mécanique 34, selon une méthode de traitement de surface appropriée.

Plus précisément, l'élément structurel de protection mécanique 34 de la figure 6 est en forme de portion de roue, disposée sous et centrée sur l'hélice motorisée 32 qu'il protège. Son rayon est en outre supérieur à la longueur de chaque pale de l'hélice 62. Il comporte par exemple un support central 70, en forme de « U » ou autre, destiné à entourer latéralement et à se fixer sur la base 58 de l'hélice motorisée 32, une jante 72 en portion circulaire et plusieurs rayons, par exemple quatre rayons 74, 76, 78, 80 légèrement recourbés vers le haut à leurs extrémités éloignées, dont deux rayons extérieurs 74 et 80 entre les extrémités éloignées desquels s'étend circulairement la jante 72. Tous ces éléments 70, 72, 74, 76, 78 et 80 qui le constituent sont par exemple en matériau diélectrique tel que du plastique rigide ou autre.

En variante, l'élément structurel de protection mécanique 34 pourrait prendre une autre forme que la portion de roue, par exemple une forme polygonale dont les sommets constitueraient avantageusement des points de déviation privilégiée d'arcs électriques potentiels.

Pour revenir à l'exemple non limitatif de la figure 6, l'hélice motorisée 32 se trouve ainsi centrée dans le support 70 et dans le cercle partiellement formé par la jante 72. La bande conductrice 68 s'étend alors circulairement en périphérie extérieure de la jante 72, notamment au contact d'une face extérieure de cette dernière, en tant que pièce rapportée ou constituée par métallisation, linéairement le long des bordures extérieures des deux rayons extérieurs 74 et 80 jusqu'au support central 70, puis le long de l'extrémité distale du bras rigide encastré dans la base 58 de l'hélice motorisée 32. Elle est fixée le long de cette extrémité distale de manière à réaliser le raccordement électrique au potentiel de référence commun avec le bras rigide. Cette fixation peut en outre se faire également au contact électrique de l'extension latérale conductrice du pied 36A, 36B, 36C ou 36D qui se trouve sous cette extrémité distale. Ainsi, l'élément structurel de protection mécanique 34 est fixé à l'extrémité distale du bras rigide qui le porte par son support central 70, à l'aide des extrémités de la bande conductrice 68 et de la base 58 qu'il entoure.

La figure 7 illustre en perspective coupée un détail du drone aérien 10 au voisinage de l'un quelconque des trous 38A, 38B, 38C, 38D. Ce trou est identifié par la référence générale 38. Ce voisinage est également celui de l'extrémité proximale de l'un quelconque des bras rigides 20A, 20B, 20C, 20D, identifié par la référence générale 20, de l'un quelconque des contrôleurs 48A, 48B, 48C, 48D, identifié par la référence générale 48, de l'une quelconque des deux batteries 44A, 44B, identifiée par la référence générale 44, et de l'un quelconque des deux boîtiers 12A, 12B, identifié par la référence générale 12.

On y voit clairement les passages qui sont créés entre les volumes intérieurs du boîtier central 14, du boîtier 12 et du bras rigide 20 pour le passage de fils électriques. Ces volumes intérieurs communiquent entre eux pour créer un espace protégé des arcs électriques et champs électromagnétiques extérieurs compte tenu des parois en contact et électriquement conductrices du boîtier central 14, du boîtier 12 et du bras rigide 20.

Un premier ensemble de fils électriques 82, constitué d'au moins une paire de fils électriques isolés électriquement l'un de l'autre à l'aide de gaines diélectriques et torsadés en toron, raccorde électriquement au moins l'un des équipements électroniques du boîtier central 14, par exemple l'autopilote 46, le dispositif de télémesure 50, la caméra 52 ou le transmetteur vidéo 54 à la batterie 44.

Mais surtout, conformément à un troisième aspect, un deuxième ensemble de fils électriques 84, constitué de trois fils électriques chacun gainés d'une couche électriquement isolante, c'est-à-dire une couche diélectrique, et tous les trois torsadés en toron, raccorde le contrôleur 48 au moteur cylindrique 60 qu'il contrôle mais qui est déporté latéralement. De cette façon, chaque moteur cylindrique 60 de voilure est électriquement alimenté par des fils électriques 84 qui s'étendent à l'intérieur du bras rigide de déportation latérale correspondant 20 tout en étant électriquement isolés de sa paroi conductrice. Ainsi, l'alimentation électrique du moteur 60 de chaque voilure latéralement déportée est elle aussi intégralement protégée électromagnétiquement et contre les arcs électriques susceptibles d'être engendrés par toute approche d'un poste électrique, d'une ligne à haute ou très haute tension, ou de tout autre équipement source d'un champ électromagnétique intense.

La figure 8 illustre en perspective un détail du drone aérien 10 au voisinage de l'extrémité distale de l'un quelconque des bras rigides 20A, 20B, 20C, 20D, identifié par la référence générale 20. Elle illustre la sortie du deuxième ensemble de fils électriques 84 au droit du moteur 60 par le trou 66. On y voit clairement que ce trou 66, percé en partie supérieure de la base 58 dans la continuité de la languette supérieure 58A, est situé dans l'espace intérieur délimité par la bande conductrice 68 qui protège électromagnétiquement l'élément structurel de protection mécanique 34 porté par le bras rigide 20. Ainsi la sortie du deuxième ensemble de fils électriques 84 au droit du moteur 60, constituant une zone de fragilité électromagnétique du drone 10 bien qu'elle se fasse au plus près du moteur 60, notamment une zone d'amorçage d'arc électrique potentiel, est malgré tout également protégée par cette bande conductrice 68 qui détourne vers elle tout arc électrique qui serait sans cela susceptible d'endommager la sortie de fils par le trou 66.

La figure 8 illustre en outre le raccordement électrique qui se fait par contact mécanique des matériaux conducteurs entre le pied 36, identifiant de façon générale l'un quelconque des pieds 36A, 36B, 36C et 36D, la bande conductrice 68 et l'extrémité distale du bras 20.

La figure 9 illustre en coupe et en détail le raccordement de l'une quelconque des trois antennes 24, 26, 28 avec l'équipement électronique correspondant 50 ou 54 et sa fixation sur le boîtier central 14.

La base de l'antenne 24, 26 ou 28 est par exemple pourvue d'un premier connecteur coaxial 86 à broche centrale de type SMA (de l'anglais « SubMiniature version A »), tandis qu'un deuxième connecteur coaxial 88 à réceptacle central de type SMA est solidaire de l'équipement électronique 50 ou 54. Ce deuxième connecteur coaxial 88 est vissé dans un trou percé dans les parois 40 et 42 du boîtier central 14. Un écrou 90 et une rondelle frein à denture intérieure 92 assurent son maintien sans endommager le boîtier 14, notamment sa paroi extérieure conductrice 42. Le premier connecteur coaxial 86 vient se visser autour de l'extrémité supérieure filetée du deuxième connecteur coaxial 88 pour réaliser une connexion centrale 94 de l'antenne 24, 26 ou 28 avec l'équipement électronique 50 ou 54. Cette connexion centrale 94 est entourée d'une couche cylindrique électriquement isolante 96, c'est-à-dire une couche diélectrique, à l'intérieur du deuxième connecteur coaxial 88.

Le deuxième connecteur coaxial 88 (à l'exception de sa couche cylindrique intérieure 96), la rondelle frein 92 et l'écrou 90 sont conçus en matériau électriquement conducteur, par exemple en laiton. La portion d'équipement électronique 50 ou 54 visible sur la figure 9 est alors avantageusement en matériau électriquement conducteur de manière à réaliser le raccordement électrique au potentiel de référence mentionné précédemment au niveau de la base de l'antenne 24, 26 ou 28. Cette dernière est quant à elle avantageusement gainée dans un matériau électriquement isolant, c'est-à-dire un matériau diélectrique, de sorte que, dans la figure 9, la gaine de l'antenne 24, 26 ou 28, la couche cylindrique intérieure 96 du deuxième connecteur coaxial 88 et la paroi 40 du boîtier 14 sont électriquement isolantes.

Il apparaît clairement qu'un véhicule aérien sans humain à bord tel que celui décrit précédemment permet d'approcher avec une sécurité optimale des zones à champ électromagnétique intense, telles que des postes électriques ou lignes de transmission et/ou distribution d'électricité à haute ou très haute tension ou tout autre équipement électrique source d'un champ électromagnétique intense.

On notera toutefois que les premier, deuxième et troisième aspects présentés précédemment relèvent de concepts inventifs indépendants bien qu'ils soient avantageusement complémentaires.

Ainsi, un drone aérien selon le premier aspect peut présenter une ou plusieurs voilure(s) quelconque(s), notamment pas nécessairement motorisée(s), à hélice(s) ou latérale(s), avec ou sans élément(s) structurel(s) de protection mécanique. Il peut s'agir de voilure fixe, mobile (par exemple à hélice), ou même hybride, c'est-à-dire associant une partie fixe (telle qu'une aile par exemple) et une partie mobile (telle qu'une hélice par exemple). Le boîtier 14 intégrant les équipements électroniques n'est pas non plus nécessairement central. En particulier, en l'absence d'élément structurel de protection mécanique de voilure, la question d'une combinaison avec le deuxième aspect de la présente invention ne se pose pas. En particulier également, en l'absence de voilure motorisée déportée latéralement par un bras rigide, la question d'une combinaison avec le troisième aspect ne se pose pas non plus.

De même, un drone aérien selon le deuxième aspect de la présente invention peut présenter une ou plusieurs voilure(s) tournante à hélice(s) motorisée(s) sans qu'elle(s) soi(en)t nécessairement latéralement déportée(s). Le boîtier 14 intégrant les équipements électroniques n'est pas non plus nécessairement central. En particulier, en l'absence de voilure motorisée déportée latéralement par un bras rigide, la question d'une combinaison avec le troisième aspect ne se pose pas. Il serait en outre possible d'envisager un drone selon le deuxième aspect de la présente invention dans lequel les équipements électroniques du boîtier 14 ne seraient pas raccordés à un potentiel électrique de référence commun formé par sa paroi conductrice, ce qui ne serait alors pas conforme au premier aspect.

De même, un drone aérien selon le troisième aspect peut présenter une ou plusieurs voilure(s) motorisée(s) latéralement déportée(s) à l'aide d'un ou plusieurs bras rigide(s) sans qu'elle(s) soi(en)t nécessairement à hélice(s) et à élément(s) structurel(s) de protection mécanique. Il peut s'agir de voilure motorisée fixe, mobile (par exemple à hélice), ou même hybride. En particulier, en l'absence d'élément structurel de protection mécanique de voilure, la question d'une combinaison avec le deuxième aspect de la présente invention ne se pose pas. Il serait en outre possible d'envisager un drone selon le troisième aspect dans lequel les équipements électroniques du boîtier 14 ne seraient pas raccordés à un potentiel électrique de référence commun formé par sa paroi conductrice, ce qui ne serait alors pas conforme au premier aspect.

On notera par ailleurs, et comme cela vient d'être démontré ci-dessus, que l'invention n'est pas limitée au mode de réalisation décrit précédemment.

Il a par exemple été illustré et décrit un drone à quatre contrôleurs de quatre moteurs d'hélices respectifs déportés latéralement à l'aide de quatre bras s'étendant à partir du boîtier 14. Mais pour un drone à déportation latérale de voilures motorisées, on peut plus généralement envisager N voilures déportées, avec N≥2 et pas nécessairement égal à quatre. Dans ce cas, différents modes de réalisation impliquant N contrôleurs de N moteurs d'hélices respectifs déportés latéralement à l'aide d'au plus N bras s'étendant à partir du boîtier 14 sont envisageables.

Il apparaîtra plus généralement à l'homme de l'art que diverses modifications peuvent lui être apportées à la lumière de l'enseignement qui vient de lui être divulgué, sans sortir de la portée des revendications ci-jointes.

## Revendications

1. Véhicule aérien (10) sans humain à bord comportant :
- une source d'alimentation électrique autonome (12 ; 44A, 44B),
- un boîtier (14) dans le volume intérieur duquel sont disposés des équipements électroniques (46, 48A, 48B, 48C, 48D, 50, 52, 54, 56) alimentés électriquement par la source d'alimentation (12; 44A, 44B), parmi lesquels un autopilote électronique (46), au moins un contrôleur (48 ; 48A, 48B, 48C, 48D) d'au moins un moteur (60) d'hélice (62) et un émetteur/récepteur radiofréquence (50) pour un actionnement télécommandé en propulsion ou sustentation du véhicule aérien (10), le boîtier (14) comportant une paroi conductrice d'électricité (42) s'étendant de manière à protéger ces équipements électroniques (46, 48A, 48B, 48C, 48D, 50, 52, 54, 56) de tout champ électromagnétique extérieur au boîtier (14),
- au moins une voilure tournante (16A, 16B, 16C, 16D) à hélice motorisée (32 ; 32A, 32B, 32C, 32D) de maintien en vol par propulsion ou sustentation sur télécommande des équipements électroniques, et
- pour chaque hélice motorisée (32 ; 32A, 32B, 32C, 32D), un élément structurel de protection mécanique (34 ; 34A, 34B, 34C, 34D),
**caractérisé en ce qu'**une bande conductrice d'électricité (68) électriquement raccordée à la paroi conductrice (42) du boîtier (14) s'étend en périphérie de chaque élément structurel (34 ; 34A, 34B, 34C, 34D) de protection mécanique d'hélice en tant qu'élément rapporté ou constitué par dépôt direct d'un matériau électriquement conducteur en périphérie de l'élément structurel (34 ; 34A, 34B, 34C, 34D) de protection mécanique selon une méthode de traitement de surface.

2. Véhicule aérien (10) sans humain à bord selon la revendication 1, dans lequel le matériau électriquement conducteur de la bande conductrice d'électricité (68) est distinct du matériau constitutif de l'élément structurel (34 ; 34A, 34B, 34C, 34D) de protection mécanique.

3. Véhicule aérien (10) sans humain à bord selon la revendication 1 ou 2, dans lequel :
- chaque élément structurel de protection mécanique (34 ; 34A, 34B, 34C, 34D) est en forme de portion de roue, disposée sous et centrée sur l'hélice (32 ; 32A, 32B, 32C, 32D) qu'il protège, dont le rayon est en outre supérieur à la longueur de chaque pale de l'hélice qu'il protège, et
- chaque bande conductrice (68) s'étend circulairement en périphérie extérieure de chaque portion de roue.

4. Véhicule aérien (10) sans humain à bord selon la revendication 3, dans lequel :
- chaque élément structurel de protection mécanique (34 ; 34A, 34B, 34C, 34D) en forme de portion de roue comporte un support central (70), au milieu duquel est montée l'hélice motorisée (32 ; 32A, 32B, 32C, 32D) correspondante, une jante (72) en portion circulaire et plusieurs rayons (74, 76, 78, 80) s'étendant latéralement depuis le support central (70) vers la jante (72), dont deux rayons extérieurs (74, 80) entre les extrémités éloignées desquels s'étend la jante (72), et
- chaque bande conductrice (68) s'étend circulairement en périphérie extérieure de la jante (72) et linéairement le long des deux rayons extérieurs (74, 80) jusqu'au support central (70) de l'élément structurel de protection mécanique (34 ; 34A, 34B, 34C, 34D) qui la porte.

5. Véhicule aérien (10) sans humain à bord selon l'une quelconque des revendications 1 à 4, comportant plusieurs voilures tournantes (16A, 16B, 16C, 16D) à hélices motorisées (32 ; 32A, 32B, 32C, 32D), chaque voilure tournante étant déportée latéralement à l'aide d'un bras (20 ; 20A, 20B, 20C, 20D) s'étendant à partir d'un châssis (18) sur lequel est monté le boîtier (14) et chaque bande conductrice (68) étant raccordée électriquement au boîtier (14) par l'intermédiaire du bras (20 ; 20A, 20B, 20C, 20D) correspondant.

6. Véhicule aérien (10) sans humain à bord selon les revendications 4 et 5, dans lequel chaque élément structurel de protection mécanique (34 ; 34A, 34B, 34C, 34D) est fixé à l'extrémité déportée de l'un des bras (20 ; 20A, 20B, 20C, 20D) par son support central (70), à l'aide au moins de la bande conductrice (68) qu'il porte.

7. Véhicule aérien (10) sans humain à bord selon l'une quelconque des revendications 1 à 6, comportant un pied (36 ; 36A, 36B, 36C, 36D) d'appui au sol sous chacune d'au moins une partie de ladite au moins une voilure tournante (16A, 16B, 16C, 16D).

8. Véhicule aérien (10) sans humain à bord selon la revendication 7, dans lequel chaque pied (36 ; 36A, 36B, 36C, 36D) d'appui au sol est formé d'au moins une partie enveloppante en matériau conducteur d'électricité et une partie de consolidation en matériau de résistance mécanique plus élevée que la partie enveloppante.

9. Véhicule aérien (10) sans humain à bord selon la revendication 8, dans lequel la partie enveloppante en matériau conducteur de chaque pied (36 ; 36A, 36B, 36C, 36D) d'appui au sol est raccordée électriquement à la bande conductrice (68) de l'élément structurel de protection mécanique (34 ; 34A, 34B, 34C, 34D) d'hélice correspondant.

10. Véhicule aérien (10) sans humain à bord selon l'une quelconque des revendications 1 à 9, dans lequel chaque élément structurel de protection mécanique (34 ; 34A, 34B, 34C, 34D) d'hélice est en matériau diélectrique.

11. Véhicule aérien (10) sans humain à bord selon l'une quelconque des revendications 1 à 10, dans lequel chaque hélice motorisée (32 ; 32A, 32B, 32C, 32D) comporte un moteur électrique (60) à protection électromagnétique intégrée et une hélice (62) à pales en matériau diélectrique vissée sur le moteur électrique (60) à l'aide d'un écrou (64) en matériau diélectrique ou recouvert d'un capuchon en matériau diélectrique.

## Patentansprüche

1. Unbemanntes Luftfahrzeug (10), das beinhaltet:
- eine autonome Stromversorgungsquelle (12; 44A, 44B),
- ein Gehäuse (14) in dessen Innenvolumen elektronische Geräte (46, 48A, 48B, 48C, 48D, 50, 52, 54, 56), die durch die Versorgungsquelle (12; 44A, 44B) elektrisch versorgt werden, angeordnet sind, darunter ein elektronischer Autopilot (46), mindestens eine Steuereinheit (48; 48A, 48B, 48C, 48D) mindestens eines Motors (60) eines Propellers (62), und ein Hochfrequenz-Sender/Empfänger (50) für eine ferngesteuerte Betätigung zum Vortrieb oder Schweben des Luftfahrzeugs (10), wobei das Gehäuse (14) eine Strom leitende Wand (42) beinhaltet, die sich erstreckt, um diese elektronischen Geräte (46, 48A, 48B, 48C, 48D, 50, 52, 54, 56) vor jedem elektromagnetischen Feld außerhalb des Gehäuses (14) zu schützen,
- mindestens einen Drehflügel (16A, 16B, 16C, 16D) mit motorisiertem Propeller (32; 32A, 32B, 32C, 32D) zum Flugerhaltung durch Vortrieb oder Schweben durch Fernsteuern der elektronischen Geräte, und
- für jeden motorisierten Propeller (32; 32A, 32B, 32C, 32D) ein Strukturelement zum mechanischen Schutz (34; 34A, 34B, 34C, 34D),
**dadurch gekennzeichnet, dass** sich ein Stromleitungsband (68), das elektrisch an die leitende Wand (42) des Gehäuses (14) angeschlossen ist, am Umfang eines jeden Strukturelements (34; 34A, 34B, 34C, 34D) zum mechanischen Schutz des Propellers als beigebrachtes, oder gemäß einem Oberflächenbehandlungsverfahren durch direktes Abscheiden eines elektrisch leitenden Materials gebildetes Element, am Umfang des Strukturelements (34; 34A, 34B, 34C, 34D) zum mechanischen Schutz erstreckt.

2. Unbemanntes Luftfahrzeug (10) nach Anspruch 1, wobei sich das elektrisch leitende Material des Stromleitungsbandes (68) vom Material unterscheidet, aus dem das Strukturelement (34; 34A, 34B, 34C, 34D) zum mechanischen Schutz besteht.

3. Unbemanntes Luftfahrzeug (10) nach Anspruch 1 oder 2, wobei:
- jedes Strukturelement zum mechanischen Schutz (34; 34A, 34B, 34C, 34D) in Form eines Radabschnitts ist, der unter und auf dem Propeller (32; 32A, 32B, 32C, 32D), den er schützt, zentriert angeordnet ist, dessen Radius weiter größer als die Länge einer jeden Schaufel des Propellers ist, den er schützt, und
- jedes Stromleitungsband (68) sich kreisförmig am Außenumfang eines jeden Radabschnitts erstreckt.

4. Unbemanntes Luftfahrzeug (10) nach Anspruch 3, wobei:
- jedes Strukturelement zum mechanischen Schutz (34; 34A, 34B, 34C, 34D) in Form eines Radabschnitts eine zentrale Stütze (70) beinhaltet, in deren Mitte der entsprechende motorisierte Propeller (32; 32A, 32B, 32C, 32D) montiert ist, ein Radkranz (72) im kreisförmigen Abschnitt und mehrere Speichen (74, 76, 78, 80), die sich seitlich aus der zentralen Stütze (70) heraus in Richtung des Radkranzes (72) erstrecken, darunter zwei äußere Speichen (74, 80) zwischen deren entfernten Enden sich der Radkranz (72) erstreckt, und
- jedes Stromleitungsband (68) sich kreisförmig am Außenumfang des Radkranzes (72) und linear entlang der beiden äußeren Speichen (74, 80) bis zur zentralen Stütze (70) des Strukturelements zum mechanischen Schutz (34; 34A, 34B, 34C, 34D), die es stützt, erstreckt.

5. Unbemanntes Luftfahrzeug (10) nach einem der Ansprüche 1 bis 4, das mehrere Drehflügel (16A, 16B, 16C, 16D) mit motorisierten Propellern (32; 32A, 32B, 32C, 32D) beinhaltet, wobei jeder Drehflügel mithilfe eines Armes (20; 20A, 20B, 20C, 20D) seitlich versetzt ist, der sich aus einem Gestell (18) erstreckt, auf dem das Gehäuse (14) montiert ist, und jedes Stromleitungsband (68) anhand des entsprechenden Armes (20; 20A, 20B, 20C, 20D) elektrisch an das Gehäuse (14) angeschlossen ist.

6. Unbemanntes Luftfahrzeug (10) nach den Ansprüchen 4 und 5, wobei jedes Strukturelement zum mechanischen Schutz (34; 34A, 34B, 34C, 34D) durch seine zentrale Stütze (70) mithilfe von mindestens dem Stromleitungsband (68), das sie stützt, am versetzten Ende des einen der Arme (20; 20A, 20B, 20C, 20D) fixiert ist.

7. Unbemanntes Luftfahrzeug (10) nach einem der Ansprüche 1 bis 6, das einen Fuß (36; 36A, 36B, 36C, 36D) zum Abstützen am Boden unter jedem von mindestens einem Teil des mindestens einen Drehflügels (16A, 16B, 16C, 16D) beinhaltet.

8. Unbemanntes Luftfahrzeug (10) nach Anspruch 7, wobei jeder Fuß (36; 36A, 36B, 36C, 36D) zum Abstützen am Boden aus mindestens einem umhüllenden Teil aus Stromleitungsmaterial und einem Konsolidierungsteil aus einem Material mit höherer mechanischer Festigkeit als der umhüllende Teil gebildet ist.

9. Unbemanntes Luftfahrzeug (10) nach Anspruch 8, wobei der umhüllende Teil aus Stromleitungsmaterial eines jeden Fußes (36; 36A, 36B, 36C, 36D) zum Abstützen am Boden elektrisch an das Stromleitungsband (68) des Strukturelements zum mechanischen Schutz (34; 34A, 34B, 34C, 34D) eines entsprechenden Propellers angeschlossen ist.

10. Unbemanntes Luftfahrzeug (10) nach einem der Ansprüche 1 bis 9, wobei jedes Strukturelement zum mechanischen Schutz (34; 34A, 34B, 34C, 34D) eines Propellers aus dielektrischem Material ist.

11. Unbemanntes Luftfahrzeug (10) nach einem der Ansprüche 1 bis 10, wobei jeder motorisierte Propeller (32; 32A, 32B, 32C, 32D) einen Elektromotor (60) mit integriertem elektromagnetischem Schutz und einen Propeller (62) mit Schaufeln aus dielektrischem Material beinhaltet, der mithilfe einer Mutter (64) aus dielektrischem Material, oder mit einer Kappe aus dielektrischem Material abgedeckt, auf den Elektromotor (60) geschraubt ist.

## Claims

1. An unmanned aerial vehicle (10) comprising:
- a self-contained electrical power source (12; 44A, 44B),
- a housing (14) in the interior volume of which electronic equipment (46, 48A, 48B, 48C, 48D, 50, 52, 54, 56) electrically powered by the power source (12; 44A, 44B) is arranged, including an electronic autopilot (46), at least one controller (48 ; 48A, 48B, 48C, 48D) of at least one propeller (62) motor (60) and a radio-frequency transmitter/receiver (50) for remote-controlled propulsion or lift actuation of the aerial vehicle (10), the housing (14) comprising an electrically conductive wall (42) extending so as to protect this electronic equipment (46, 48A, 48B, 48C, 48D, 50, 52, 54, 56) from any electromagnetic field outside the housing (14),
- at least one rotary wing (16A, 16B, 16C, 16D) with a motorized propeller (32; 32A, 32B, 32C, 32D) for maintaining flight by propulsion or lift on remote control of electronic equipment, and
- for each motorized propeller (32; 32A, 32B, 32C, 32D), a mechanical protection structural element (34; 34A, 34B, 34C, 34D),
**characterized in that** an electrically conductive strip (68) electrically connected to the conductive wall (42) of the housing (14) extends at the periphery of each propeller's mechanical protection structural element (34; 34A, 34B, 34C, 34D) as an add-on element or formed by direct deposition of an electrically conductive material at the periphery of the mechanical protection structural element (34; 34A, 34B, 34C, 34D) by a surface treatment method.

2. The unmanned aerial vehicle (10) according to claim 1, wherein the electrically conductive material of the electrically conductive strip (68) is distinct from the material constituting the structural element (34; 34A, 34B, 34C, 34D) for mechanical protection.

3. The unmanned aerial vehicle (10) according to claim 1 or 2, wherein:
- each mechanical protection structural element (34; 34A, 34B, 34C, 34D) is in the form of a wheel portion, arranged below and centered on the propeller (32; 32A, 32B, 32C, 32D) that it protects, the radius of which is further greater than the length of each blade of the propeller it protects, and
- each conductive strip (68) extends circularly at the outer periphery of each wheel portion.

4. The unmanned aerial vehicle (10) according to claim 3, wherein:
- each mechanical protection structural element (34; 34A, 34B, 34C, 34D) in the form of a wheel portion comprises a central support (70), in the middle of which the corresponding motorized propeller (32; 32A, 32B, 32C, 32D) is mounted, a rim (72) in the form of a circle portion and a number of spokes (74, 76, 78, 80) extending laterally from the central support (70) towards the rim (72), including two outer spokes (74, 80), between the remote ends of which the rim (72) extends, and
- each conductive strip (68) extends circularly at the outer periphery of the rim (72) and linearly along the two outer spokes (74, 80) to the central support (70) of the mechanical protection structural element (34; 34A, 34B, 34C, 34D) carrying it.

5. The unmanned aerial vehicle (10) according to any of claims 1 to 4, comprising a plurality of rotary wings (16A, 16B, 16C, 16D) with motorized propellers (32; 32A, 32B, 32C, 32D), each rotary wing being offset laterally by means of an arm (20 ; 20A, 20B, 20C, 20D) extending from a frame (18) on which the housing (14) is mounted, and each conductive strip (68) being electrically connected to the housing (14) via the corresponding arm (20; 20A, 20B, 20C, 20D).

6. The unmanned aerial vehicle (10) according to claims 4 and 5, wherein each mechanical protection structural element (34; 34A, 34B, 34C, 34D) is fixed to the remote end of one of the arms (20; 20A, 20B, 20C, 20D) by its central support (70), using at least the conductive strip (68) which it carries.

7. The unmanned aerial vehicle (10) of any one of claims 1 to 6, comprising a ground support foot (36; 36A, 36B, 36C, 36D) under each of at least part of said at least one rotary wing (16A, 16B, 16C, 16D).

8. The unmanned aerial vehicle (10) according to claim 7, wherein each ground support foot (36; 36A, 36B, 36C, 36D) is formed by at least one enveloping part made of an electrically conductive material and a reinforcing part made of a material with a higher mechanical strength than the enveloping part.

9. The unmanned aerial vehicle (10) according to claim 8, wherein the enveloping part made of conductive material of each ground support foot (36; 36A, 36B, 36C, 36D) is electrically connected to the conductive strip (68) of the corresponding propeller's mechanical protection structural element (34; 34A, 34B, 34C, 34D).

10. The unmanned aerial vehicle (10) according to any one of claims 1 to 9, wherein each propeller's mechanical protection structural element (34; 34A, 34B, 34C, 34D) is made of dielectric material.

11. The unmanned aerial vehicle (10) according to any one of claims 1 to 10, wherein each motorized propeller (32; 32A, 32B, 32C, 32D) comprises an electric motor (60) with integrated electromagnetic protection and a propeller (62) with blades made of dielectric material screwed onto the electric motor (60) by means of a nut (64) made of dielectric material or covered by a cap made of dielectric material.
